# EUROPEAN PATENT APPLICATION

(11) **EP 2 107 607 A2**
(43) Date of publication of application: **07.10.2009**
(21) Application number: 09250959.5
(22) Date of filing: 30.03.2009
(51) Int. Cl.: H01L 23/66

(54) **High frequency semiconductor circuit device**

(30) Priority: 31.03.2008 JP 2008091226
(71) Applicant: Kabushiki Kaisha Toshiba, Minato-ku Tokyo (JP)
(72) Inventor: Tamura, Koichi, Minato-ku Tokyo (JP)
(74) Representative: Granleese, Rhian Jane

(57) **Abstract**

A high frequency semiconductor circuit device in which a microwave circuit can be miniaturized is provided, which includes a GaAs substrate; a plurality of FETs formed on the GaAs substrate; and a microstrip line formed on the GaAs substrate and electrically connecting FETs each other, wherein a thickness of a region of the GaAs substrate on which the microstrip line is formed is different from a thickness of a region of the GaAs substrate on which FETs are formed.

## Description

### CROSS REFERENCE TO RELATED APPLICATIONS

This application is based upon and claims the benefit of priority from the prior Japanese Patent Application No.2008-091226 filed in Japan on March 31, 2008; the entire contents of which are incorporated herein by reference.

### TECHNICAL FIELD

The present invention relates to a semiconductor circuit device formed microstrip lines on a substrate and operating in a high frequency band.

### BACKGROUND ART

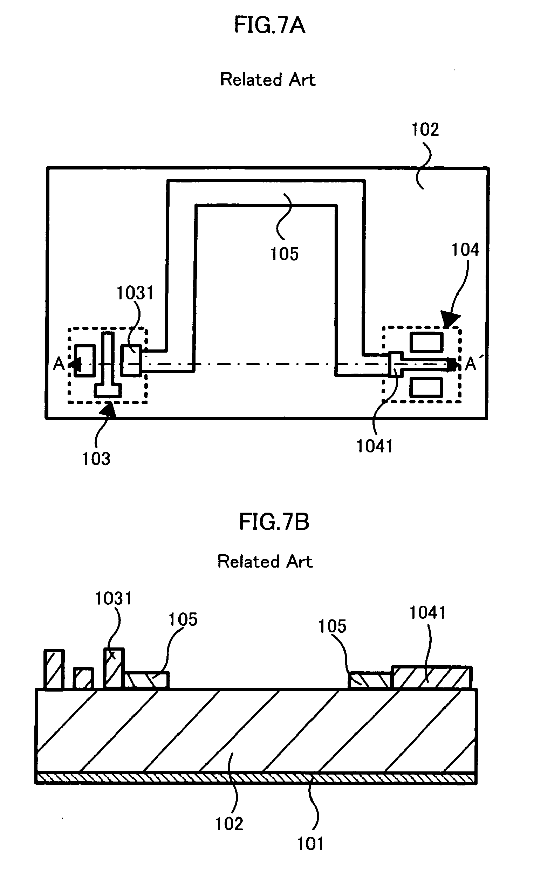

In a conventional semiconductor circuit device, a microstrip line, which is a fine metal line, has been used as a transmission line for connecting active devices to transmit a microwave in a microwave circuit formed on a dielectric substrate. Referring to FIGS. 7A and 7B, such a semiconductor circuit device will be described below.

FIG. 7A is a top view illustrating the conventional semiconductor circuit device. FIG. 7B is a sectional view taken along the broken line A-A' in FIG. 7A.

The conventional semiconductor circuit device includes at least two field effect transistors 103, 104 (hereinafter referred to as "FET(s)") formed, as shown in FIG. 7A, on a GaAs substrate 102 having a conductor 101 over the entire rear face thereof. The conductor 101 has a fixed thickness as shown in FIG. 7B. A drain electrode 1031 of, for example, one FET 103 of the two FETs and a gate electrode 1041 of the other FET 104 are interconnected through a microstrip line 105.

The microstrip line 105 is formed to be curved due to a restriction of device arrangement in a circuit pattern and a restriction of impedance matching with two FETs 103, 104.

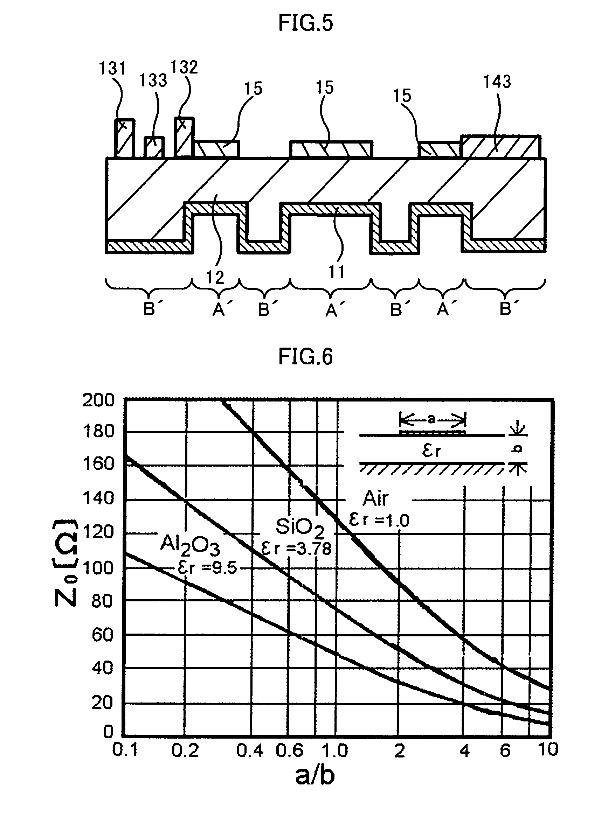

The characteristic impedance of the microstrip line 105 is determined by a length and a width of the microstrip line 104 and a thickness of the GaAs substrate 102. FIG. 6 illustrates a relationship between the line width a, the substrate thickness b and the characteristic impedance Z₀ at a fixed line length. FIG. 6 shows that, as the line width a is narrower and the thickness b of the GaAs substrate 102 is thicker, the characteristic impedance Z₀ of the microstrip line 105 becomes higher. Further, although not illustrated in FIG. 6, it has been known that, as the line length is longer, the characteristic impedance Z₀ becomes higher.

Conventionally, the characteristic impedance Z₀ of the microstrip line 105 has been defined by mainly adjusting the line width a. However, attainment of the microstrip line 104 especially having a low impedance characteristic requires resolution of the following problems:

Specifically, in order to attain the low impedance characteristic, the line width a has to be wide as shown in FIG. 6. This is because the length of the microstrip line 104 cannot be shortened due to the restrictions such as the device arrangement described above. Accordingly, the area occupied by the microstrip line 105 on a surface of the GaAs substrate 102 on which the microwave circuit is formed has become larger. Increasing the line width a of the microstrip line 105 in this way causes the problem that the size of the microwave circuit becomes larger. Further, when the line width a of the microstrip line 105 is increased, there is also a problem that the electric power of a microwave emitted from the microstrip line 105 to the open air increases.

Accordingly, to avoid the foregoing problems, there has been known a semiconductor circuit device in which a width of an effective microstrip line is increased by attaching a plurality of adjusting lines in parallel to the microstrip line in the vicinity of a junction point between the microstrip line and an active device and connecting the adjusting line to the microstrip line(Japanese Patent Application Laid-Open No.1994-196950).

According to this semiconductor circuit device, the part of the line where the line width is wide is only the vicinity of the junction with an active device and therefore enlargement of the microwave circuit resulting from increasing the line width can be restrained. However, attachment of a plurality of adjusting lines on the substrate is required, which disadvantageously results in that manufacture of the microwave circuit is difficult. In addition, the line width is wide even locally and therefore further miniaturization of the microwave circuit is difficult.

In addition, it has been known that only the region where FET is formed, the semiconductor substrate is thinly formed to improve discharge characteristics of FET (Japanese Patent Application Laid-Open No.1993-235194).

### DISCLOSURE OF THE INVENTION

It is one of the objects of the present invention to provide a high frequency semiconductor circuit device in which a microwave circuit on a substrate can be miniaturized.

According to one aspect of the present invention, there is provided a semiconductor circuit device including: a dielectric substrate; a plurality of active devices formed on the dielectric substrate; and a microstrip line formed on the dielectric substrate and electrically connecting the active devices, wherein a thickness of a first region of the dielectric substrate on which the microstrip line is formed is different from a thickness of a second region of the dielectric substrate on which the active devices are formed.

### BRIEF DESCRIPTION OF THE DRAWINGS

FIG. 1A is a top view schematically illustrating a high frequency semiconductor circuit device according to a first embodiment of the present invention;
FIG. 1B is a sectional view taken along a broken line A-A' in FIG. 1A;
FIG. 2 is a sectional view for illustrating a manufacturing method for the semiconductor circuit device according to the first embodiment of the present invention;
FIG. 3 is a sectional view for illustrating a manufacturing method for the semiconductor circuit device according to the first embodiment of the present invention;
FIG. 4A is a top view schematically illustrating the semiconductor circuit device according to the first embodiment of the present invention;
FIG. 4B is a sectional view taken along a broken line A-A' in FIG. 4A;
FIG. 5 is a sectional view schematically illustrating a modified example of the semiconductor circuit device according to the first embodiment of the present invention;
FIG. 6 is a view illustrating a relationship between a line width, a substrate thickness and a characteristic impedance at a fixed line length of a microstrip line;
FIG. 7A is a top view schematically illustrating a conventional semiconductor circuit device; and
FIG. 7B is a sectional view taken along a broken line A-A' in FIG. 7A.

### DETAILED DESCRIPTION OF THE EMBODIMENTS

Embodiments of the present invention will be described with reference to the accompanying drawings.

### [First Embodiment]

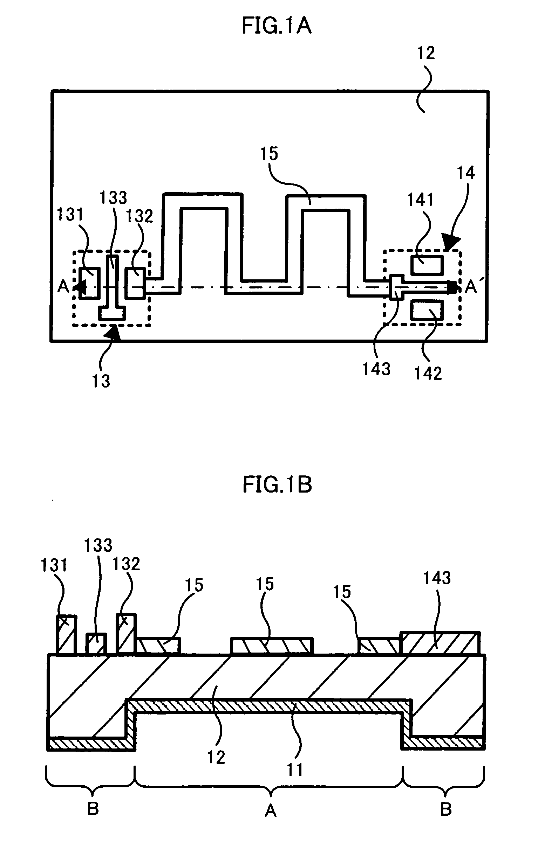

FIG. 1A is a top view schematically illustrating a high frequency semiconductor circuit device with a microwave circuit according to a first embodiment of the present invention. FIG. 1B is a sectional view taken along a broken line A-A' in FIG. 1A.

As shown in FIG. 1B, the microwave circuit in the semiconductor circuit device according to the first embodiment is formed on a GaAs substrate 12 having a conductor 11 on a rear face thereof.

As shown in FIG. 1A, the microwave circuit includes, for example, two FETs 13, 14 functioning as active devices, and a microstrip line 15 connecting FET 13 to FET 14 each other.

The FET 13 has a source electrode 131, a drain electrode 132 and a gate electrode 133. Similarly, the FET 14 has a source electrode 141, a drain electrode 142 and a gate electrode 143. The microstrip line 15 connects, for example, the drain electrode 132 of the FET 13 to the gate electrode 143 of the FET 14 each other. Such a microstrip line 14 is made of, for example, Au.

The thickness of a region A of the GaAs substrate 12 on which the microstrip line 15 is formed is thinner than the thickness of a region B of the GaAs substrate 12 on which FETs 13, 14 are formed.

By thinning the thickness of the region A of the GaAS substrate 12 on which the microstrip line 15 is formed, the characteristic impedance of the microstrip line 15 can be reduced without changing the length of the microstrip line 15. Accordingly, the line width of the microstrip line 14 can be narrower than a line with of a conventional microstrip line. Accordingly, when the line width of the microstrip line 14 is narrow in this way, the characteristic impedance of the microstrip line 14 sufficient to match an impedance of the FET 13 with an impedance of the FET 14 can be maintained.

As described above, since the line width of the microstrip line 15 can be narrow, an area occupied by the microstrip line 15 can be smaller than an area occupied by the conventional microstrip line. Accordingly, the microwave circuit can be miniaturized.

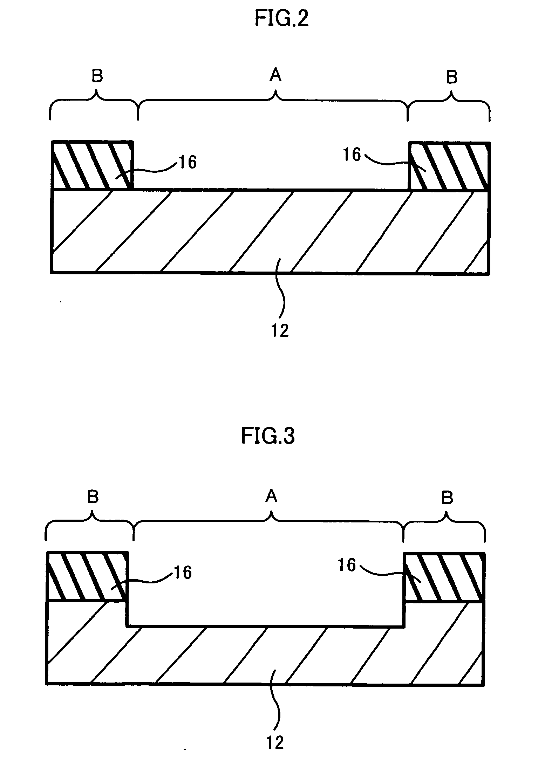

Referring next to FIGS. 2 and 3, description will be made on a manufacturing method for the GaAs substrate 11 with partially different thickness as described above.

First, a photosensitive resist is formed on the entire rear face of the GaAs substrate 12 and a resist mask 16 as shown in FIG. 2 is formed by patterning. The resist mask 16 has an opening in a region A in which the microstrip line 15 is formed on the GaAs substrate 11.

Next, as shown in FIG. 3, a part of the GaAs substrate 11 is selectively removed by reactive ion etching (RIE) through the resist mask 16.

Finally, by removing the resist mask 16, the GaAs substrate 12 with partially different thickness as described in the present embodiment can be formed.

### [Second Embodiment]

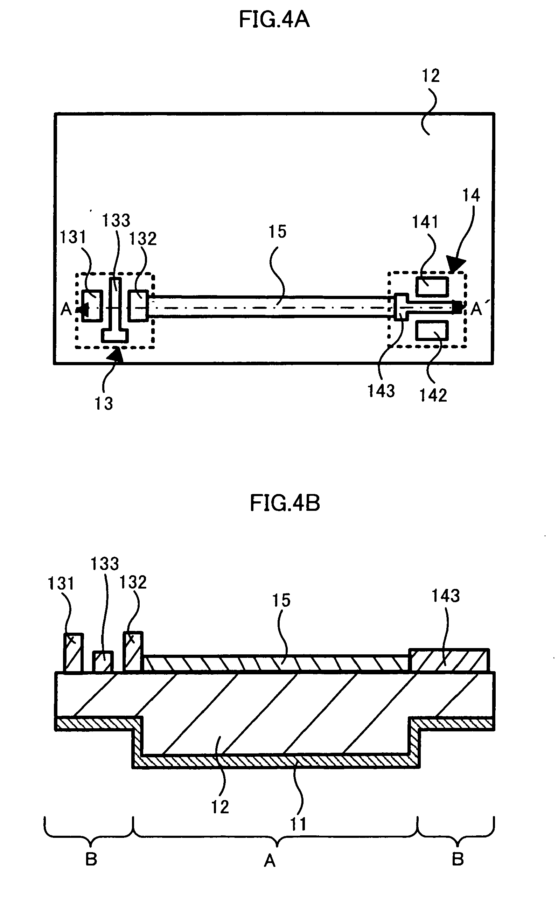

Referring next to FIG. 4A and FIG. 4B, a second embodiment of the present invention will be described below.

FIG. 4A is a top view schematically illustrating a high frequency semiconductor circuit device with a microwave circuit according to the second embodiment of the present invention. FIG. 4B is a sectional view taken along a broken line A-A' in FIG. 4A.

The semiconductor circuit device according to the second embodiment is different from the semiconductor circuit device according to the first embodiment in the following respects:

The thickness of the region A of the GaAs substrate 12 on which the microstrip line 15 is formed is thicker than the thickness of the region B of the GaAs substrate 12 on which FETs 13, 14 are formed.

By making thicker the thickness of the region A of the GaAs substrate 12 on which the microstrip line 15 is formed, a characteristic impedance of the microstrip line 15 can be increased without changing the width of the microstrip line 15. Accordingly, when a length of the microstrip line 15 is shortened, a characteristic impedance of the microstrip line 15 sufficient to match the impedance of the FET 13 with the impedance of the FET 14 can be maintained. In this case, since the line length can be shortened, the area occupied by the microstrip line 15 can be smaller than the area occupied by the conventional microstrip line. Accordingly, the microwave circuit can be miniaturized.

The design for forming the microstrip line 15 is not limited by impedance matching, but limited by only device arrangement. Therefore, the flexibility in designing a circuit pattern can also be enhanced.

The semiconductor circuit device according to the second embodiment is also excellent in the effect of radiating the heat generated at FETs 13, 14 because the thickness of the region B of the GaAs substrate 12 on which FETs 13, 14 are formed is thin.

A manufacturing method for a GaAs substrate 11 in the semiconductor circuit device according to the second embodiment is essentially the same as that in the semiconductor circuit device according to the first embodiment and therefore detailed description thereof will not be repeated, but simple description will be made below.

According to the manufacturing method for the GaAs substrate 11 in the semiconductor circuit device according to the second embodiment, a resist mask having an opening in the region B of the GaAs substrate 11 and etching is performed using the resist to form the substrate 11.

Embodiments of the present invention have been described above, but embodiments are not limited thereto, and various changes and modifications may be made in the present invention without any departure from the spirit and scope thereof.

For example, in the above-described embodiments, the thickness of the entire region A of the GaAs substrate 12 on which the microstrip line 15 is formed is different from the thickness of the region B of the GaAs substrate 12 on which FETs 13,14 are formed. However, the thickness of the region A of the GaAs substrate 12 may be adjusted along the shape of the microstrip line 14. Specifically, as shown in FIG. 5 which is a sectional view taken along the broken line A-A', the thickness of only a region A' with a microstrip line 15 formed on a surface of the GaAs substrate 12 is thinner than that of any other region B' with FETs 13, 14 formed on a surface of the GaAs substrate 12. In this case, the flexibility in designing the microstrip line 15 formed on the GaAs substrate 12 is enhanced.

In the respective embodiments, description has been made on a case where the GaAs substrate 12 is used as a dielectric substrate. However, any dielectric substrate, which has conductivity and includes a dielectric with a dielectric constant of approximately 1 to 10, is applicable. For example, Si or Al₂O₃ is also applicable as the dielectric.

In the respective embodiments described above, description has been made on the microstrip line 15 made of Au. However, the microstrip line 15 may use any metal.

Further, in the respective embodiments described above, description has been made on a case where two FETs 13, 14 are electrically connected. However, an element to be connected is not limited to a FET. Specifically, the present invention is applicable to a case where any of an active device, a passive device and a circuit including the active device and the passive device is required to be connected through a microstrip line for matching.

## Claims

1. A high frequency semiconductor circuit device comprising:
a dielectric substrate;
a plurality of active devices formed on the dielectric substrate; and
a microstrip line formed on the dielectric substrate and electrically connecting the active devices, wherein
a thickness of a first region of the dielectric substrate on which the microstrip line is formed is different from a thickness of a second region of the dielectric substrate on which the active devices are formed.

2. The semiconductor circuit device according to claim 1, wherein the thickness of the entire first region is thinner than the thickness of the second region.

3. The semiconductor circuit device according to claim 1, wherein the thickness of a part of the first region is thinner than the thickness of the second region.

4. The semiconductor circuit device according to claim 1, wherein the thickness of the first region is thicker than the thickness of the second region.

5. The semiconductor circuit device according to any preceding claim, wherein the active device is a field effect transistor.

6. The semiconductor circuit device according to any preceding claim, wherein the dielectric substrate is made of any of GaAs, Si and Al₂O₃.

7. The semiconductor circuit device according to any preceding claim, wherein the microstrip line is made of Au.
